# EUROPÄISCHE PATENTSCHRIFT

(11) **EP 1 770 834 B1**
(45) Veröffentlichungstag und Bekanntmachung des Hinweises auf die Patenterteilung: **16.09.2009**
(21) Anmeldenummer: 06020601.8
(22) Anmeldetag: 29.09.2006
(51) Int. Cl.: H01S 5/183, H01S 5/14, H01S 5/024, H01S 5/06, H01S 5/04, H04N 9/31

(54) **Optisch gepumpter oberflächenemittierender Halbleiterlaser und optische Projektionsvorrichtung mit solch einem Halbleiterlaser**
Surface emitting semiconductor laser device and optical projection device comprising the same
Dispositif laser semi-conducteur à émission de surface et dispositif de projection optique l'utilisant

(30) Priorität: 29.11.2005 DE 102005056949; 30.09.2005 DE 102005047147
(43) Veröffentlichungstag der Anmeldung: 04.04.2007
(73) Patentinhaber: OSRAM Opto Semiconductors GmbH, 93055 Regensburg (DE)
(72) Erfinder: Kühnelt, Michael, 93051 Regensburg (DE); Steegmüller, Ulrich, 93055 Regensburg (DE); Reill, Wolfgang, 93080 Pentling (DE); Schwarz, Thomas, 93051 Regensburg (DE); Singer, Frank, 93128 Regenstauf (DE)
(74) Vertreter: Epping - Hermann - Fischer

(56) Entgegenhaltungen:
- EP-A- 1 693 936
- WO-A2-20/05107027
- DE-A1- 10 043 896
- US-A1- 2001 012 307
- US-B1- 6 693 941
- STEEGMULLER U ET AL: "High speed green frequency converted semiconductor laser for projection displays" DIGEST OF TECHNICAL PAPERS - SID INTERNATIONAL SYMPOSIUM; 2005 SID INTERNATIONAL SYMPOSIUM, BOSTON, MA, USA, 25-27 MAY 2005, Bd. 36, Nr. 2, 25. Mai 2005 (2005-05-25), Seiten 1608-1609, XP001244411
- LINDBERG H ET AL: "Single-frequency operation of a high-power, long-wavelength semiconductor disk laser" OPTICS LETTERS OPT. SOC. AMERICA USA, Bd. 30, Nr. 17, 1. September 2005 (2005-09-01), Seiten 2260-2262, XP009076932 ISSN: 0146-9592

## Beschreibung

Es wird ein optisch gepumpter oberflächenemittierender Halbleiterlaser angegeben. Darüber hinaus wird eine optische Projektionsvorrichtung mit solch einem optisch gepumpten oberflächenemittierenden Halbleiterlaser angegeben.

Die Druckschrift US 2005/0036528 beschreibt einen optisch gepumpten oberflächenemittierenden Halbleiterlaser. Bei diesem Halbleiterlaser befindet sich eine transparente Wärmesenke in thermischen Kontakt mit einer strahlungserzeugenden Schichtenfolge.

Die Druckschrift US 2001/012307 A1 beschreibt einen oberflächenemittierenden Halbleiterlaser mit einer ringförmigen Elektrode, die zur Unterdrückung von Resonatormoden vorgesehen und direkt auf den Halbleiterkörper des Lasers aufgebracht ist.

Die Druckschrift Lindberg H. et al.: "Single-frequency operation of a high-power, long-wavelength semiconductor disk laser", Optics Letters, Bd. 30, Nr. 17, 1. September 2004, pp. 2260-2262, beschreibt einen optisch gepumpten Halbleiter-Scheibenlaser, mit einer Diamant-Wärmesenke, die auf den Scheibenlaser aufgebracht ist.

Die Druckschrift Steegmüller U. et al.: "High speed green frequency converted semiconductor laser for projection displays", International Symposium; 2005 SID, Boston, MA, USA, 25-27 May 2005, Bd. 36, Nr. 2, 25. Mai 2005, pp 1608-1609, beschreibt einen kompakten grünen Laser für eine Projektionsvorrichtung.

Eine zu lösende Aufgabe besteht unter anderem darin, einen optisch gepumpten oberflächenemittierenden Halbleiterlaser mit einer zeitlich besonders stabilen Laseremission anzugeben.

Diese Aufgabe wird mit einem optisch gepumpter oberflächenemittierender Halbleiterlaser gemäß Patentanspruch 1 gelöst.

Es wird ein optisch gepumpter oberflächenemittierender Halbleiterlaser angegeben. Gemäß zumindest einer Ausführungsform des Halbleiterlasers umfasst der optisch gepumpte oberflächenemittierende Halbleiterlaser einen Halbleiterkörper mit einer Halbleiter-Schichtenfolge. Die Halbleiter-Schichtenfolge umfasst unter anderem eine zur Strahlungserzeugung geeignete Schichtenfolge, die zum Beispiel einen pn-Übergang, eine Einfach-Quantentopfstruktur oder eine Mehrfach-Quantentopfstruktur enthalten kann.

Der Halbleiterkörper umfasst vorzugsweise ferner eine reflektierende Schicht oder Schichtenfolge, die geeignet ist, zumindest einen Teil der in der zur Strahlungserzeugung vorgesehenen Schichtenfolge erzeugten elektromagnetischen Strahlung zu reflektieren. Die reflektierende Schichtenfolge umfasst dazu zum Beispiel einen Bragg-Spiegel.

In der strahlungserzeugenden Schichtenfolge im Betrieb des Halbleiterlasers erzeugte elektromagnetische Strahlung tritt durch eine Strahlungsdurchtrittsfläche aus dem Halbleiterkörper aus. Die Strahlungsdurchtrittsfläche ist dabei durch eine Hauptfläche des Halbleiterkörpers gebildet, die auf einer der reflektierenden Schichtenfolge abgewandten Seite der strahlungserzeugenden Schichtenfolge angeordnet ist.

Der optisch gepumpte oberflächenemittierende Halbleiterlaser weist bevorzugt einen weiteren Spiegel auf, der extern, das heißt, vom Halbleiterkörper entfernt, angeordnet ist. Der externe Spiegel und die reflektierende Schichtenfolge des Halbleiterkörpers bilden einen Resonator, in dem in der strahlungserzeugenden Schichtenfolge erzeugte und / oder verstärkte elektromagnetische Strahlung umlaufen kann.

Der optisch gepumpte oberflächenemittierende Halbleiterlaser weist ferner eine Pumpstrahlquelle auf. Die Pumpstrahlquelle ist vorzugsweise außerhalb des Halbleiterkörpers angeordnet. Die Pumpstrahlquelle kann zum Beispiel derart angeordnet sein, dass sie Pumpstrahlung durch die Strahlungsdurchtrittsfläche des Halbleiterkörpers in die strahlungserzeugende Schichtenfolge des Halbleiterkörpers liefert. Die Pumpstrahlung erzeugt beispielsweise in der strahlungserzeugenden Schichtenfolge des Halbleiterkörpers Ladungsträgerpaare. Durch Rekombination der Ladungsträgerpaare wird dann elektromagnetische Strahlung erzeugt. Die derart erzeugte elektromagnetische Strahlung kann den Halbleiterkörper durch die Strahlungsdurchtrittsfläche verlassen.

Bei der Pumpstrahlquelle handelt es sich beispielsweise um einen oder mehrere kantenemittierende Halbleiterlaser, zum Beispiel um einen oder mehrere Diodenlaser.

Der optisch gepumpte oberflächenemittierende Halbleiterlaser weist weiter eine modenselektive Vorrichtung auf. Die modenselektive Vorrichtung ist zur Unterdrückung vorgebbarer, höherer transversaler Resonatormoden geeignet. Das heißt, die modenselektive Vorrichtung ist vorgesehen, Resonatormoden ab einer bestimmten, vorgebbaren Modenzahl zu unterdrücken. Das bedeutet, ein Anschwingen dieser höheren Resonatormoden im durch die reflektierende Schichtenfolge und den externen Spiegel gebildeten Resonator wird von der modenselektiven Vorrichtung verhindert. Beispielsweise ist die modenselektive Vorrichtung geeignet, das Anschwingen aller Moden bis auf die transversale Grundmode des Resonators zu verhindern. Im Resonator kann dann lediglich die transversale Grundmode anschwingen. Die modenselektive Vorrichtung ist dabei im Resonator des optisch gepumpten oberflächenemittierenden Halbleiterlasers, das heißt, zwischen dem externen Spiegel und der reflektierenden Schichtenfolge angeordnet.

Dabei ist die modenselektive Vorrichtung fest mit dem Halbleiterkörper des Halbleiterlasers verbunden.

Gemäß zumindest einer Ausführungsform des optisch gepumpten oberflächenemittierenden Halbleiterlasers ist die modenselektive Vorrichtung im Strahlengang der Pumpstrahlquelle angeordnet. Das heißt, Pumpstrahlung tritt auf ihrem Weg zur strahlungserzeugenden Schichtenfolge des Halbleiterkörpers durch die modenselektive Vorrichtung. Dabei ist es möglich, dass die Pumpstrahlung von der modenselektiven Vorrichtung optisch beeinflusst wird. Es ist aber auch möglich, dass die Pumpstrahlung im Wesentlichen von der modenselektiven Vorrichtung ungestört durch diese treten kann. Im Wesentlichen ungestört heißt, dass keine oder kaum Wechselwirkung zwischen der modenselektiven Vorrichtung und der Pumpstrahlung stattfindet. Die Intensität des Pumpstrahls - und damit die Pumpleistung - wird durch die modenselektive Vorrichtung dann nicht oder nur geringfügig reduziert.

Durch die Anordnung der modenselektiven Vorrichtung im Strahlengang der Pumpstrahlquelle ist es möglich, die modenselektive Vorrichtung möglichst nahe an der Strahlungsdurchtrittsfläche des Halbleiterkörpers anzuordnen.

Gemäß zumindest einer Ausführungsform des optisch gepumpten oberflächenemittierenden Halbleiterlasers ist die modenselektive Vorrichtung geeignet, zumindest einen Teil der Pumpstrahlung optisch zu beeinflussen. Die modenselektive Vorrichtung kann zum Beispiel geeignet sein, die Richtung oder die Intensität eines Teils der Pumpstrahlung zu verändern. Die Vorrichtung kann dazu beispielsweise geeignet sein, einen Teil der Pumpstrahlung zu absorbieren, zu reflektieren und/oder optisch zu brechen.

Der hier beschriebene optisch gepumpte oberflächenemittierende Halbleiterlaser macht sich dabei unter anderem die Idee zunutze, dass die modenselektive Vorrichtung, wenn sie im Strahlengang der Pumpstrahlquelle angeordnet ist, eine Mehrfachfunktion erfüllen kann. So kann die modenselektive Vorrichtung zum einen zur Selektion unerwünschter höherer Resonatormoden des Lasers geeignet sein. Des Weiteren kann die modenselektive Vorrichtung geeignet sein, das Profil der Pumpstrahlung in vorgebbarer Weise zu verändern. Durch teilweise Absorption der Pumpstrahlung mittels der modenselektiven Vorrichtung kann etwa erreicht sein, dass nur bestimmte Bereiche der strahlungserzeugenden Schichtenfolge des Halbleiterkörpers optisch gepumpt werden. Auf diese Weise ist ein gewünschtes Pumpprofil in der strahlungserzeugenden Schichtenfolge einstellbar. Damit kann mit der modenselektiven Vorrichtung das Anregungsprofil und damit das Strahlprofil der zu erzeugenden Laserstrahlung gezielt eingestellt werden. Weiter kann durch Absorption oder Reflexion eines Teils der Pumpstrahlung durch die modenselektive Vorrichtung ein Aufheizen des Halbleiterkörpers durch die Pumpstrahlung reduziert werden. Dies erweist sich für das thermische Verhalten des Halbleiterlasers als besonders vorteilhaft.

Gemäß zumindest einer Ausführungsform weist die modenselektive Vorrichtung einen Unterdrückungsbereich auf, der geeignet ist, die auf ihn treffende, im Resonator umlaufende elektromagnetische Strahlung derart zu beeinflussen, dass sie der Resonatorleistung verloren geht.
Der Unterdrückungsbereich der modenselektiven Vorrichtung ist zum Beispiel geeignet, auf ihn treffende elektromagnetische Strahlung zu absorbieren, zu reflektieren und/oder optisch zu brechen. Der Unterdrückungsbereich kann dabei auch geeignet sein, die Richtung eines Teils der im Resonator umlaufenden Laserstrahlung zu verändern, sodass dieser Teil der Strahlung aus dem Resonator hinausgebrochen wird und nicht mehr zur Lasererzeugung beitragen kann. Der Unterdrückungsbereich kann aber auch geeignet sein, einen Teil der durch ihn tretenden Laserstrahlung abzuschwächen oder vollständig zu absorbieren.

Gemäß zumindest einer Ausführungsform des optisch gepumpten oberflächenemittierenden Halbleiterlasers weist die modenselektive Vorrichtung neben dem Unterdrückungsbereich einen Bereich auf, durch den im Resonator umlaufende Strahlung im Wesentlichen ungestört durchtreten kann. Dieser Anteil der im Resonator umlaufenden Laserstrahlung wird von der modenselektiven Vorrichtung kaum oder gar nicht optisch beeinflusst. Dieser Anteil der im Resonator umlaufenden Laserstrahlung kann in den zur Strahlungserzeugung vorgesehenen Bereich des Halbleiterkörpers gelangen und dort durch induzierte Emission verstärkt werden.

Gemäß zumindest einer Ausführungsform des optisch gepumpten oberflächenemittierenden Halbleiterlasers ist die Größe des Bereichs, durch den im Laserresonator umlaufende Strahlung im Wesentlichen ungestört treten kann, derart gewählt, dass lediglich die transversale Grundmode des Resonators anschwingen kann. Das heißt, lediglich Laserstrahlung der transversalen Grundmode wird dann durch die modenselektive Vorrichtung, das heißt, insbesondere durch den Unterdrückungsbereich, nicht gestört, sodass nur diese Mode im Resonator anschwingt.

Der hier beschriebene optisch gepumpte oberflächenemittierende Halbleiterlaser macht sich dabei unter anderem die Erkenntnis zunutze, dass die transversale Grundmode einen kleineren Strahldurchmesser als höhere transversale Moden aufweist. Durch die Wahl des Durchmessers eines beispielsweise kreisförmig gewählten Gebiets können dann diejenigen Moden ausgewählt werden, die im Resonator anschwingen sollen. Je größer dieser Durchmesser gewählt ist, desto höhere transversale Moden können im Resonator anschwingen. Bevorzugt ist der Durchmesser des Gebiets dann so gewählt, dass lediglich die transversale Grundmode anschwingt.

Die modenselektive Vorrichtung befindet sich in direktem Kontakt mit der Strahlungsdurchtrittsfläche des Halbleiterkörpers. Das heißt, die modenselektive Vorrichtung ist auf die Strahlungsdurchtrittsfläche des Halbleiterkörpers aufgebracht. Die modenselektive Vorrichtung umfasst dazu eine Metallbeschichtung, die auf die Strahlungsdurchtrittsfläche des Halbleiterkörpers aufgebracht ist. Die modenselektive Vorrichtung kann dann beispielsweise durch eine ringförmige Beschichtung gebildet sein, die ein Metall enthält. Die ringförmige Beschichtung weist eine Öffnung auf, die den Bereich der modenselektiven Vorrichtung bildet, durch den Laserstrahlung im Wesentlichen ungestört durchtreten kann. Der Unterdrückungsbereich der modenselektiven Vorrichtung ist dann durch das Metall der ringförmigen Beschichtung gebildet, die auftreffende Strahlung absorbiert und/oder reflektiert.

Die Metallbeschichtung weist dabei eine Dicke von höchstens 15 nm auf. Elektromagnetische Strahlung wird durch die Metallschicht dann nicht vollständig absorbiert, sondern lediglich abgeschwächt. Das heißt zum Beispiel, dass Pumpstrahlung, die auf die Metallbeschichtung trifft, dann abgeschwächt durch die Strahlungsdurchtrittsfläche in den Halbleiterkörper gelangen kann. Im Resonator umlaufende Strahlung trifft jedoch bei jedem Umlauf auf die Metallbeschichtung und wird dabei immer stärker abgeschwächt, sodass ein Anschwingen von höheren transversalen Moden unterbunden wird.

Gemäß zumindest einer Ausführungsform ist ein optisch nicht linearer Kristall im Resonator des Halbleiterlasers angeordnet. Vorzugsweise ist der optisch nicht lineare Kristall zur Frequenzkonversion zumindest eines Teils der im Resonator umlaufenden Laserstrahlung vorgesehen.

Gemäß zumindest einer Ausführungsform der Laservorrichtung umfasst der optisch nicht lineare Kristall zumindest einen der folgenden Kristalle: Lithiumtriborat z.B. LiB₃O₅ (LBO), Wismuttriborat z.B. BiB₃O₆ (BiBO), Kaliumtitanylphosphat KTiOPO₄ (KTP), magnesiumoxiddotiertes kongruentes Lithiumniobat z.B. MgO:LiNbO₃ (MgO:LN), magnesiumoxiddotiertes stöchiometrisches Lithiumniobat z.B. MgO:s-LiNbO₃ (MgO:SLN), magnesiumoxiddotiertes stöchiometrisches Lithiumtantalat z.B. MgO:LiTaO₃ (MgO:SLT), stöchiometrisches LiNbO₃ (SLN), stöchiometrisches LiTaO₃ (SLT), RTP (RbTiOPO₄), KTA (KTiOAsO₄), RTA (RbTiOAsO₄), CTA (CsTiOAsO₄).

Bevorzugt ist der optisch nicht lineare Kristall zur Frequenzverdoppelung der ihn durchtretenden Strahlung geeignet.

Es wird darüber hinaus eine optische Projektionsvorrichtung angegeben, die wenigstens einen optisch gepumpten oberflächenemittierenden Halbleiterlaser aufweist, wie er in Verbindung mit den oben aufgeführten Ausführungsformen beschrieben ist. Ferner kann die Projektionsvorrichtung beispielsweise eine Ansteuerelektronik zur Ansteuerung des Lasers und ein Gehäuse, in das Ansteuerelektronik und optisch gepumpter oberflächenemittierender Halbleiterlaser integriert sind, aufweisen. Eine solche optische Projektionsvorrichtung eignet sich besonders gut, für die Verwendung in einem Multimedia-Projektor oder in einem Rückprojektions-Fernsehgerät. Aufgrund seiner kompakten Größe kann eine solche optische Projektionsvorrichtung auch in Kleingeräten wie beispielsweise Mobilfunktelefonen Verwendung finden.

Im Folgenden wird der hier beschriebene Halbleiterlaser anhand von Ausführungsbeispielen und den dazugehörigen Figuren näher erläutert.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.
Figur 1 zeigt eine schematische Schnittdarstellung des hier beschriebenen optisch gepumpten oberflächenemittierenden Halbleiterlasers gemäß einem ersten Ausführungsbeispiel.
Figur 2A zeigt eine schematische Schnittdarstellung eines Halbleiterkörpers gemäß einem zweiten und dritten Ausführungsbeispiel des hier beschriebenen optisch gepumpten oberflächenemittierenden Halbleiterlasers.
Figur 2B zeigt eine schematische Aufsicht auf den Halbleiterkörper gemäß dem zweiten und dritten Ausführungsbeispiel des hier beschriebenen optisch gepumpten oberflächenemittierenden Halbleiterlasers.
Figur 3 zeigt eine schematische Schnittdarstellung einer Projektionsvorrichtung gemäß einem Ausführungsbeispiel.

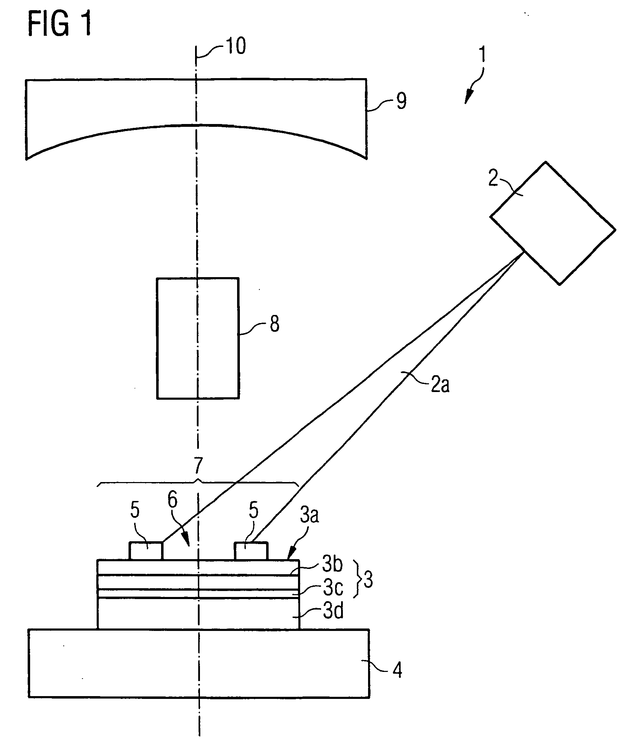

Figur 1 zeigt eine schematische Schnittdarstellung des hier beschriebenen optisch gepumpten oberflächenemittierenden Halbleiterlasers gemäß einem ersten Ausführungsbeispiel.

Der Halbleiterlaser umfasst einen Halbleiterkörper 3. Der Halbleiterkörper 3 ist mit einen Träger 3d verbunden. Der Halbleiterkörper 3 umfasst eine reflektierende Schichtenfolge 3c. Außerdem umfasst der Halbleiterkörper 3 eine strahlungserzeugende Schichtenfolge 3b. Elektromagnetische Strahlung kann den Halbleiterkörper durch die Strahlungsdurchtrittsfläche 3a verlassen oder in den Halbleiterkörper 3 durch die Strahlungsdurchtrittsfläche 3a eintreten.

Bei dem Träger 3d kann es sich um ein Aufwachssubstrat handeln. Die reflektierende Schichtenfolge 3c und die strahlungsemittierende Schichtenfolge 3b sind dann auf den Träger 3d vorzugsweise epitaktisch aufgewachsen. Dabei kann der Träger 3d auch ein gedünntes Aufwachssubstrat sein, dessen Dicke auf höchstens 100 µm reduziert ist. Handelt es sich bei dem Träger 3d um ein Aufwachssubstrat oder um ein gedünntes Aufwachssubstrat, so enthält oder besteht der Träger 3d vorzugsweise aus Galliumarsenid.

Ferner ist es möglich, dass es sich bei dem Träger 3d um einen nach Abschluss des Wachstums der Schichten des Halbleiterkörpers 3 auf die dem ursprünglichen Aufwachssubstrat abgewandte Oberfläche des Halbleiterkörpers 3 aufgebrachten Träger 3d handelt. Das Aufwachssubstrat ist dann von den epitaktisch gewachsenen Schichtenfolgen 3c und 3b entfernt. Bei dem Träger 3d kann es sich in diesem Fall zum Beispiel um eine galvanisch abgeschiedene Schicht oder Schichtenfolge handeln.

Bei der strahlungsreflektierenden Schichtenfolge 3c handelt es sich um eine reflektierende Metallschicht, einen Bragg-Spiegel oder um eine Kombination dieser reflektierenden Schichten. Im Ausführungsbeispiel der Figur 1A handelt es sich bei der reflektierenden Schichtenfolge 3b um einen Bragg-Spiegel. Der Bragg-Spiegel weist eine Mehrzahl von Halbleiterschichtenpaaren mit einem vorteilhaft hohen Brechungsindexunterschied auf. Beispielsweise bilden je eine Galliumarsenid- und eine Aluminiumgalliumarsenid-λ/4-Schicht ein Halbleiterschichtenpaar. Die Mehrzahl von Schichtenpaaren im Bragg-Spiegel ist in Figur 1 durch die Schicht 3c schematisch angedeutet. Bevorzugt umfasst der Bragg-Spiegel eine Abfolge von 20 - 30 oder mehr Halbleiterschichtenpaaren, woraus eine besonderes hohe Reflektivität des Bragg-Spiegels von 99,9 % oder mehr resultiert. Mit Vorteil ist der Bragg-Spiegel gemeinsam mit den übrigen Halbleiterschichtenfolgen des Halbleiterkörpers 3 epitaktisch hergestellt.

Die strahlungserzeugende Schichtenfolge 3b umfasst vorzugsweise einen aktiven Bereich mit einem pn-Übergang, einer Einfach-Quantentopfstruktur oder bevorzugt einer Mehrfach-Quantentopfstruktur, die zur Strahlungserzeugung geeignet ist. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Vorzugsweise basiert die strahlungsemittierende Schichtenfolge 3b auf einem III-V-Verbindungshalbleitermaterial. Das heißt, die strahlungsemittierende Schichtenfolge 3b umfasst mindestens eine Schicht, die aus einem III-V-Verbindungshalbleitermaterial besteht. Bevorzugt basiert die strahlungsemittierende Schichtenfolge 3b auf einem Nitrid-, Phosphid- oder besonders bevorzugt Arsenid-Verbindungshalbleiter.

"Auf Nitrid-Verbindungshalbleitern basierend" bedeutet im vorliegenden Zusammenhang, dass die strahlungsemittierende Schichtenfolge 3b oder zumindest eine Schicht davon ein Nitrid- V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘn-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass die strahlungsemittierende Schichtenfolge 3b oder zumindest eine Schicht davon vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass die strahlungsemittierende Schichtenfolge 3b oder zumindest eine Schicht davon vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Diese Materialien zeichnen sich durch vereinfacht erreichbare hohe interne Quanteneffizienzen aus und eignen sich für Strahlung vom ultravioletten (insbesondere Nitrid-basiertes Verbindungshalbleitermaterial) über den sichtbaren (insbesondere Phosphid-basierte Verbindungshalbleitermaterialien) bis in den infraroten Spektralbereich (insbesondere Arsenid-basierte Verbindungshalbleitermaterialien).

Bevorzugt basiert die strahlungserzeugende Schichtenfolge 3b des Halbleiterkörpers 3 auf einem Arsenid-Verbindungshalbleitermaterial. Strahlung im infraroten Spektralbereich, insbesondere im Wellenbereich zwischen 800 nm und 1100 nm, kann in diesem Materialsystem besonders effizient erzeugt werden. Beispielsweise enthält der Träger 3d Galliumarsenid und die strahlungsemittierende Schichtenfolge 3b oder zumindest eine Schicht davon basiert auf dem Materialsystem AlₙGaₘIn₁₋ₙ₋ₘAs mit 0 ≤ n ≤ 1, 0 ≤ m ≤ 1 und n+m ≤ 1.

Der Halbleiterkörper 3 ist mit seinem Träger 3d auf einen Träger 4 aufgebracht, beispielsweise aufgelötet. Der Träger 4 besteht bevorzugt aus einem gut Wärme leitenden Material wie beispielsweise einem Kupfer- oder einem Kupferverbundwerkstoff.

Der optisch gepumpte oberflächenemittierende Halbleiterlaser weist weiter eine Pumpstrahlquelle 2 auf, die geeignet ist, Pumpstrahlung 2a - vorzugsweise Laserstrahlung - zu erzeugen. Die Pumpstrahlquelle 2 ist beispielsweise durch einen oder mehrere Diodenlaser gegeben. Außerdem kann der Pumpstrahlquelle eine optische Anordnung beispielsweise umfassend zumindest eine Linse in Abstrahlrichtung nachgeordnet sein, die die Pumpstrahlung 2a auf den Halbleiterkörper 3 fokussiert.

Weiter weist der Halbleiterlaser einen externen Spiegel 9 auf. Der externe Spiegel 9 weist zum Beispiel eine konkav gekrümmte Oberfläche auf.

Im optisch gepumpten Halbleiterkörper 3 kann auf diese Weise Laserstrahlung erzeugt werden, die im Resonator, der durch die reflektierende Schichtenfolge 3c und den zumindest einen externen Spiegel 9 gebildet ist, umläuft.

Ferner kann im Laserresonator ein optisch nicht linearer Kristall 8 angeordnet sein, der zum Beispiel zur Frequenzverdoppelung geeignet ist.

Der externe Spiegel 9 weist in diesem Fall für die in der strahlungsemittierenden Schichtenfolge 3b erzeugte elektromagnetische Strahlung eine besonders hohe Reflektivität und für den frequenzkonvertierten Anteil der Strahlung eine hohe Transmittivität auf.

Für einen wie in Figur 1A schematisch dargestellten Halbleiterlaser ergibt sich nun bei einem beispielhaft gewählten Krümmungsradius des externen Spiegels 9 von -15 mm und einer Resonatorlänge von 10 mm ein Strahldurchmesser für die im Resonator umlaufende Laserstrahlung an der Strahlungsdurchtrittsfläche 3a des Halbleiterkörpers 3, der abhängig von der transversalen Modenzahl ist. Die transversale Grundmode TEM₀₀ weist in diesem Rechenbeispiel einen Strahldurchmesser von ca..100 µm gemessen an der Strahlungsdurchtrittsfläche 3a auf. Die transversale Mode TEM₁₁ weist einen Strahldurchmesser von ca. 170 µm gemessen an der Strahlungsdurchtrittsfläche 3a auf. Die transversale Mode TEM₂₂ weist einen Strahldurchmesser von ca. 210 µm gemessen an der Strahlungsdurchtrittsfläche 3a auf.

Der hier beschriebene optisch gepumpte oberflächenemittierende Halbleiterlaser macht sich nun die Idee zunutze, dass durch eine modenselektive Vorrichtung 7 das Anschwingen von Moden, die einen größeren Durchmesser als eine vorgebbare transversale Mode aufweisen, verhindert werden kann. Auf diese Weise ist ein Halbleiterlaser ermöglicht, der beispielsweise einen stabilen Grundmodenbetrieb bei effizienter Nutzung der Pumpstrahlung 2a erlaubt. Da die Grundmode einen kleineren Strahldurchmesser aufweist als die höheren transversalen Moden, verbessert sich auch die Konversionseffizienz bei der Frequenzverdoppelung im optisch nicht linearen Kristall 8. Ein Modenrauschen als Ursache für Leistungsinstabilität ist wirksam unterdrückt.

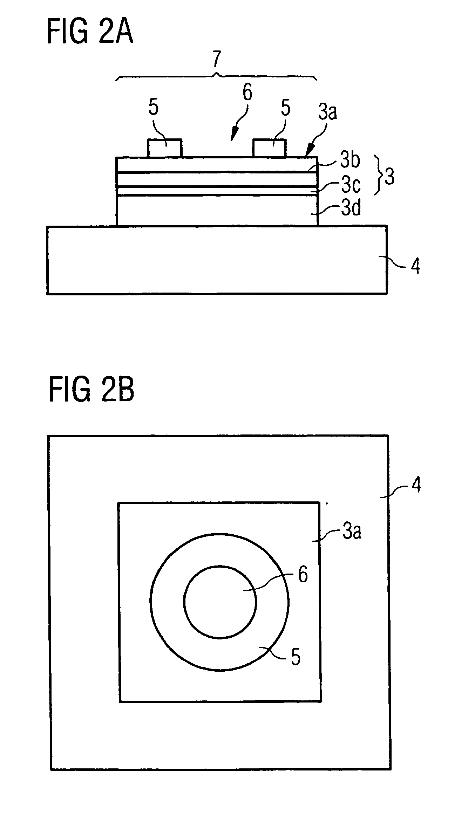

Figur 2A zeigt eine schematische Schnittdarstellung des Scheibenlasers mit Halbleiterkörper 3, Träger 4 und modenselektiver Vorrichtung 7 nach einem zweiten Ausführungsbeispiel des optisch gepumpten oberflächenemittierenden Halbleiterlasers. Figur 2B zeigt schematisch die zugehörige Aufsicht auf den Halbleiterkörper 3.

Die modenselektive Vorrichtung 7 umfasst einen Unterdrückungsbereich 5 und eine Öffnung 6. Durch die Öffnung 6 kann im Halbleiterkörper 3 erzeugte elektromagnetische Strahlung den Halbleiterkörper 3 durch die Strahlungsdurchtrittsfläche 3a verlassen. Ferner kann Pumpstrahlung 2a durch die Öffnung 6 in den Halbleiterkörper 3 gelangen. Im Ausführungsbeispiel der Figur 2A kann der Unterdrückungsbereich 5 als dünne, semitransparente Metallschicht ausgeführt sein.

Bevorzugt enthält oder besteht der Unterdrückungsbereich 5 aus zumindest eines der folgenden Metalle, die auf der Strahlungsdurchtrittsfläche beispielsweise einen Ring bilden: Chrom, Platin, Gold. Die Schichtdicke des Metallrings beträgt bevorzugt zwischen 5 nm und 15 nm. Für die auftreffende Pumpstrahlung 2a ist eine solche Metallschicht teildurchlässig. Für das vielfach im Resonator umlaufende Laserlicht wirkt eine solche dünne Metallschicht außerhalb der Öffnung 6 als effektiver Verlustmechanismus, der bei entsprechend gewähltem Durchmesser der Öffnung höhere Resonatormoden, beispielsweise höhere Moden als die Grundmode, unterdrückt.

Das teilweise Eindringen der Pumpstrahlung 2a über die Öffnung 6 hinaus, das heißt, Durchdringen von Pumpstrahlung 2a durch den Unterdrückungsbereich 5, hat den Vorteil, dass auch Ränder der strahlungserzeugenden Schichtenfolge 3b optisch gepumpt werden und das Anregungsprofil am Rand weniger durch Ladungsträgerdiffusion im Halbleiter beeinträchtigt ist. Auch die thermische Belastung des Unterdrückungsbereichs 5 ist wegen der Durchlässigkeit gering. Allerdings wird in diesem Ausführungsbeispiel mehr Pumpleistung im Halbleiterkörper 3 absorbiert, als dies beispielsweise bei einer vollständig strahlungsundurchlässigen Metallschicht der Fall wäre. Dies kann die thermischen Eigenschaften des Halbleiterkörpers 3 negativ beeinflussen.

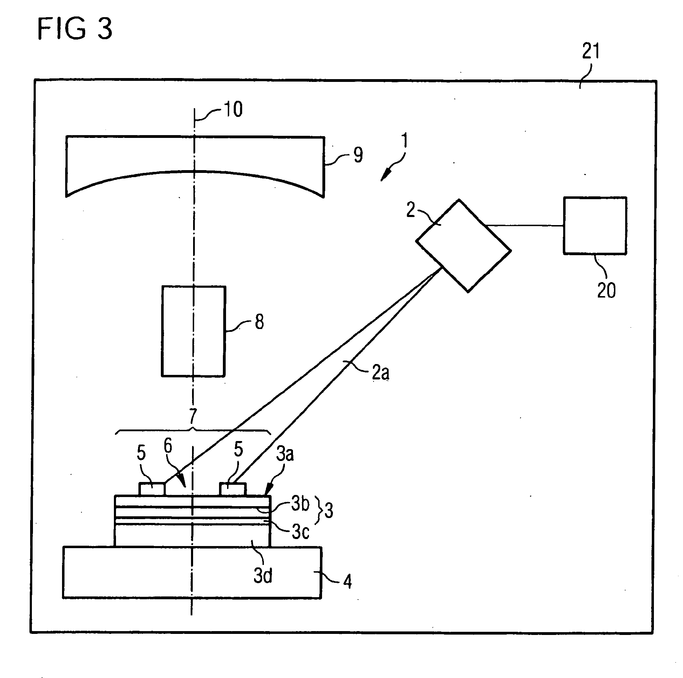

Figur 3 zeigt eine schematische Schnittdarstellung einer Projektionsvorrichtung gemäß einem Ausführungsbeispiel.

Die optische Projektionsvorrichtung weist, wenigstens einen optisch gepumpten oberflächenemittierenden Halbleiterlaser 1 auf, wie er in Verbindung mit den Figuren 1 und 2 beschrieben ist. In Ergänzung zu einem der oben beschriebenen Halbleiterlaser 1 kann die Projektionsvorrichtung ferner beispielsweise eine Ansteuerelektronik 20 beispielsweise zur Ansteuerung der Pumpstrahlquelle 2 und ein Gehäuse 21, in das Ansteuerelektronik 20 und optisch gepumpter oberflächenemittierender Halbleiterlaser 1 integriert sind, aufweisen. Bevorzugt umfasst die optische Projektionsvorrichtung eine bildgebendes Element wie zum Beispiel einen zweidimensionalen Scannerspiegel, der den über die Ansteuerelektronik 20 modulierten Laserstrahl über eine Projektionsfläche lenkt und auf diese Weise ein Bild beispielsweise auf eine Projektionsfläche aufbaut.

Eine solche optische Projektionsvorrichtung eignet sich besonders gut, für die Verwendung in einem Multimedia-Projektor oder in einem Rückprojektions-Fernsehgerät. Aufgrund seiner kompakten Größe kann eine solche optische Projektionsvorrichtung auch in Kleingeräten wie beispielsweise Mobilfunktelefonen Verwendung finden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optisch gepumpter, oberflächenemittierender Halbleiterlaser mit einer Pumpstrahlquelle (2) und einer modenselektiven Vorrichtung (7), die zur Unterdrückung von vorgebbaren, höheren transversalen Resonatormoden des Halbleiterlasers vorgesehen ist, bei dem die modenselektive Vorrichtung (7) fest mit einem Halbleiterkörper (3) des Halbleiterlasers verbunden und in einem externen Resonator des Halbleiterlaser angeordnet ist wobei die modenselektive Vorrichtung (7) eine Metallbeschichtung umfasst, die direkt auf die Strahlungsdurchtrittsfläche (3a) des Halbleiterkörpers aufgebracht ist, **dadurch gekennzeichnet, dass** die Metallbeschichtung eine Dicke von maximal 15 nm aufweist.

2. Halbleiterlaser gemäß dem vorherigen Anspruch, bei dem die modenselektive Vorrichtung (7) im Strahlengang der Pumpstrahlquelle (2) des oberflächenemittierenden Halbleiterlasers angeordnet ist.

3. Halbleiterlaser gemäß dem vorherigen Anspruch, bei dem die modenselektive Vorrichtung (7) geeignet ist, zumindest einen Teil einer Pumpstrahlung (2a) der Pumpstrahlquelle (2) optisch zu beeinflussen.

4. Halbleiterlaser gemäß zumindest einem der vorherigen Ansprüche,
bei dem die modenselektive Vorrichtung (7) einen Unterdrückungsbereich (5) aufweist, der geeignet ist, auf ihn treffende, in einem Resonator (3c, 9) des Halbleiterlasers umlaufende Laserstrahlung derart optisch zu beeinflussen, dass die Laserstrahlung der Resonatorleistung verloren geht.

5. Halbleiterlaser gemäß Anspruch 4,
bei dem der Unterdrückungsbereich (5) geeignet ist, die im Resonantor (3c, 9) umlaufende Laserstrahlung zu absorbieren.

6. Halbleiterlaser gemäß einem der Ansprüche 4 oder 5,
bei dem der Unterdrückungsbereich (5) geeignet ist, die Richtung der im Resonator (3c, 9) umlaufenden Laserstrahlung zu ändern.

7. Halbleiterlaser gemäß einem der Ansprüche 4 bis 6,
bei dem die modenselektive Vorrichtung (7) einen Bereich (6) aufweist, durch den die im Resonator (3c, 9) umlaufende Laserstrahlung vom Unterdrückungsbereich (5) ungestört durch die modenselektive Vorrichtung (7) tritt.

8. Halbleiterlaser gemäß Anspruch 7,
bei dem die Größe des Bereichs (6) derart gewählt ist, dass lediglich die transversale Grundmode des Resonators (3c, 9) anschwingen kann.

9. Halbleiterlaser gemäß zumindest einem der vorherigen Ansprüche,
bei dem die modenselektive Vorrichtung (7) geeignet ist, das Anschwingen höherer transversaler Moden als der transversalen Grundmode im Resonator (3c, 9) zu unterdrücken.

10. Halbleiterlaser gemäß zumindest einem der vorherigen Ansprüche,
bei dem wenigstens ein optisch nicht-linearer Kristall (8) im Resonator (3c, 9) des Halbleiterlasers angeordnet ist.

11. Halbleiterlaser gemäß einem der Ansprüche 2 bis 10,
bei dem die Pumpstrahlquelle (2) einen Diodenlaser umfasst.

12. Optische Projektionsvorrichtung,
mit einem Halbleiterlaser (1) gemäß zumindest einem der vorherigen Ansprüche und einer Ansteuerelektronik (21) für den Halbleiterlaser.

## Claims

1. Optically pumped, surface-emitting semiconductor laser having a pump beam source (2) and a mode-selective apparatus (7) which apparatus is intended to suppress predeterminable, higher transverse resonator modes of the semiconductor laser and in which the mode-selective apparatus (7) is firmly connected to a semiconductor body (3) of the semiconductor laser and is arranged in an external resonator of the semiconductor laser, the mode-selective apparatus (7) having a metal coating which is applied directly to a radiation exit surface (3a) of the semiconductor body through which radiation can pass, **characterized in that** the metal coating has a maximum thickness of 15 nm.

2. Semiconductor laser according to the preceding claim,
in which the mode-selective apparatus (7) is arranged in the beam path of the pump beam source (2) of the surface-emitting semiconductor laser.

3. Semiconductor laser according to the preceding claim,
in which the mode-selective apparatus (7) is suitable for optically influencing at least a portion of the pump radiation (2a) from the pump beam source (2).

4. Semiconductor laser according to at least one of the preceding claims,
in which the mode-selective apparatus (7) has a suppression area (5) which is suitable for optically influencing laser radiation which strikes it and circulates in a resonator (3c, 9) in the semiconductor laser, in such a manner that the laser radiation is lost to the resonator power.

5. Semiconductor laser according to Claim 4,
in which the suppression area (5) is suitable for absorption of the laser radiation circulating in the resonator (3c, 9).

6. Semiconductor laser according to either of Claims 4 or 5,
in which the suppression area (5) is suitable for changing the direction of the laser radiation circulating in the resonator (3c, 9).

7. Semiconductor laser according to one of Claims 4 to 6,
in which the mode-selective apparatus (7) has an area (6) through which the laser radiation circulating in the resonator (3c, 9) passes from the suppression area (5) without being disturbed by the mode-selective apparatus (7).

8. Semiconductor laser according to Claim 7,
in which the size of the area (6) is chosen in such a manner that only the transverse fundamental mode of the resonator (3c, 9) can be built up.

9. Semiconductor laser according to at least one of the preceding claims,
in which the mode-selective apparatus (7) is suitable for suppression of the excitation of higher transverse modes than the transverse fundamental mode in the resonator (3c, 9).

10. Semiconductor laser according to at least one of the preceding claims,
in which at least one optically non-linear crystal (8) is arranged in the resonator (3c, 9) in the semiconductor laser.

11. Semiconductor laser according to one of Claims 2 to 10,
in which the pump beam source (2) comprises a diode laser.

12. Optical projection apparatus,
having a semiconductor laser (1) according to at least one of the preceding claims, and having drive electronics (21) for the semiconductor laser.

## Revendications

1. Laser à semi-conducteur pompé optiquement, émettant par sa surface,
doté d'une source (2) de rayon de pompage et d'un dispositif (7) sélectif en mode prévu pour atténuer des modes plus élevés de résonance transversale prédéterminés du laser à semi-conducteur,
le dispositif (7) sélectif en mode étant relié solidairement à un corps semi-conducteur (3) du laser à semi-conducteur et étant disposé dans un résonateur externe du laser à semi-conducteur,
le dispositif (7) sélectif en mode comprenant un revêtement métallique qui est appliqué directement sur la surface (3a) de passage de rayonnement du corps semi-conducteur,
**caractérisé en ce que**
le revêtement métallique présente une épaisseur d'au plus 15 nm.

2. Laser à semi-conducteur selon la revendication précédente, dans lequel le dispositif (7) sélectif en mode est disposé dans le parcours des rayons de la source (2) de rayon de pompage du laser à semi-conducteur émettant par sa surface.

3. Laser à semi-conducteur selon la revendication précédente, dans lequel le dispositif (7) sélectif en mode convient pour agir optiquement sur au moins une partie d'un rayonnement de pompage (2a) de la source (2) de rayon de pompage.

4. Laser à semi-conducteur selon au moins l'une des revendications précédentes, dans lequel le dispositif (7) sélectif en mode présente une partie d'atténuation (5) qui convient pour agir optiquement sur le rayonnement laser qui y aboutit et qui circule dans un résonateur (3c, 9) du laser à semi-conducteur, de telle sorte que le rayonnement laser de puissance du résonateur soit perdu.

5. Laser à semi-conducteur selon la revendication 4, dans lequel la partie d'atténuation (5) convient pour absorber le rayonnement laser qui circule dans le résonateur (3c, 9).

6. Laser à semi-conducteur selon l'une des revendications 4 ou 5, dans lequel la partie d'atténuation (5) convient pour modifier la direction du rayonnement laser qui circule dans le résonateur (3c, 9).

7. Laser à semi-conducteur selon l'une des revendications 4 à 6, dans lequel le dispositif (7) sélectif en mode présente une partie (6) par laquelle le rayonnement laser qui circule dans le résonateur (3c, 9) et provenant de la partie d'atténuation (5) traverse sans perturbation le dispositif (7) sélectif en mode.

8. Laser à semi-conducteur selon la revendication 7, dans lequel la taille de la partie (6) est sélectionnée de telle sorte que seul le mode fondamental transversal du résonateur (3c, 9) puisse osciller.

9. Laser à semi-conducteur selon au moins l'une des revendications précédentes, dans lequel le dispositif (7) sélectif en mode convient pour diminuer l'oscillation des modes transversaux plus élevés que le mode fondamental transversal du résonateur (3c, 9).

10. Laser à semi-conducteur selon au moins l'une des revendications précédentes, dans lequel au moins un cristal optiquement non linéaire (8) est disposé dans le résonateur (3c, 9) du laser à semi-conducteur.

11. Laser à semi-conducteur selon l'une des revendications 2 à 10, dans lequel la source (2) de rayonnement de pompage comprend un laser à diode.

12. Dispositif de projection optique qui présente un laser (1) à semi-conducteur selon au moins l'une des revendications précédentes et une électronique de commande (21) pour le laser à semi-conducteur.
